# EUROPEAN PATENT APPLICATION

(11) **EP 4 779 342 A1**
(43) Date of publication of application: **22.07.2026**
(21) Application number: 25152438.5
(22) Date of filing: 17.01.2025
(51) Int. Cl.: G01R 33/34, G01R 33/3415

(54) **RADIO FREQUENCY COIL ASSEMBLY FOR MAGNETIC RESONANCE IMAGING**

(71) Applicant: Koninklijke Philips N.V., 5656 AE Eindhoven (NL)
(72) Inventor: FINDEKLEE, Christian, Eindhoven (NL); VERNICKEL, Peter, Eindhoven (NL); LEUSSLER, Christoph Günther, Eindhoven (NL)
(74) Representative: Philips Intellectual Property & Standards

(57) **Abstract**

A radio frequency (RF) coil assembly (500) includes a top structure (410) and a bottom structure (420). The top structure includes a first portion of an RF coil loop. The bottom structure includes a second portion of the RF coil loop. The RF coil assembly is configured to be selectively connected in at least a first configuration and a second configuration. The first configuration includes the top structure and the bottom structure. The top structure is connected to the bottom structure, and the first portion of the RF coil loop is connected to the second portion of the RF coil loop. The second configuration includes the top structure, the bottom structure, and an intermediary structure (530). The intermediary structure is detachably connected between the top structure and the bottom structure, and connects the first portion of the RF coil loop to the second portion of the RF coil loop.

## Description

### FIELD OF THE INVENTION

The present invention relates to magnetic resonance imaging (MRI), in particular to a configurable modular patient adaptive radio frequency (RF) coil system for magnetic resonance imaging of patients.

### BACKGROUND AND SUMMARY

Magnetic resonance imaging (MRI) is commonly used to provide non-invasive methods to visualize internal structure and tissue of patients.

MRI detects the nuclear magnetic resonance signals given off by protons in the presence of a strong magnetic field after excitation by a radio frequency signal. The nuclear magnetic resonance signals are detected using one or more RF coil(s) (sometime just referred to as "coils") which include one or more antenna(e), which may also be referred to as RF coil loops or RF coil elements. The term "RF coil" may be used to refer to the RF antenna(e) or RF coil loop(s) or RF coil elements, associated electronics, and the housing or support structure which includes the one or more coil loops.

Sensitivity of an RF coil to magnetic resonance signals decreases rapidly with increasing distance between the RF coil loop or RF antenna, and the volume of interest to be imaged. It is therefore desirable to place RF coils such that their one or more RF coil loops are in close proximity to the patient, and particularly the area of the patient which is to be imaged. Such RF coils are sometimes referred to as "local coils" or "local RF coils." Local RF coils are often used for imaging extremities of the body such as wrists, forearms, ankles, or knees. Local RF coils can also include head or shoulder coils. Local RF coils being local to an anatomy of interest tend to have a higher signal-to-noise ratio (SNR) than larger coils such as a "body coil" which is useful for obtaining large survey scans of the patient.

However, in general, existing local RF coil arrangements make a compromise between the patient population for which they can be deployed, and image quality since they need to be big enough for the largest patient in the target population, and therefore they exhibit lower loading for smaller patients, disposing the RF coil loop(s) further away from the area to be imaged, and consequently producing lower SNRs for these smaller patient anatomies.

It would thus be desirable to provide an RF coil assembly which can be relatively easily adapted to patient anatomies of different sizes.

In one aspect of the invention, an RF coil assembly comprises: a top structure, and a bottom structure. The top structure includes a first portion of at least a first RF coil loop, and the bottom structure includes a second portion of the first RF coil loop. The RF coil assembly is configured to be selectively connected in at least a first configuration and a second configuration. The first configuration comprises: the top structure and the bottom structure, wherein the top structure is connected to the bottom structure, and wherein the first portion of the first RF coil loop is connected to the second portion of the first RF coil loop to form the first RF coil loop. The second configuration comprises: the top structure, the bottom structure, and a first intermediary structure, wherein the first intermediary structure is detachably connected between the top structure and the bottom structure, and wherein the first intermediary structure connects the first portion of the first RF coil loop to the second portion of the first RF coil loop to form the first RF coil loop.

In one or more embodiments, the first intermediary structure includes at least one capacitor, wherein the at least one capacitor is connected in the second configuration in series between the first portion of the first RF coil loop and the second portion of the first RF coil loop.

In one or more embodiments, the first intermediary structure includes at least first and second capacitors, wherein the first capacitor is connected in the second configuration in series between the first portion of the first RF coil loop and the second portion of the first RF coil loop, and the second capacitor is connected in the second configuration in series between the first portion of the first RF coil loop and the second portion of the first RF coil loop, wherein the first capacitor and the second capacitor are disposed at opposite sides of the first RF coil loop.

In one or more embodiments, the RF coil assembly further includes a second RF coil and a decoupling area between the first RF coil loop and the second RF coil loop, wherein in the first configuration the first RF coil loop and the second RF coil loop are split at centers thereof between the top structure and the bottom structure.

In one or more embodiments, the bottom structure comprises: first bottom connections, wherein the first bottom connections are arranged for connecting the top structure or the first intermediary structure thereto when the top structure has a first size; and second bottom connections, wherein the second bottom connections are arranged for connecting the top structure or the first intermediary structure thereto when the top structure has a second size, wherein the second size is larger than the first size.

In one or more embodiments, the RF coil assembly includes one or more connections for connecting the RF coil loop(s) to at least one of a low noise amplifier, a power source, and a detuning circuit.

In one of more embodiments, the RF coil assembly is configured to be selectively connected in at least the first configuration, the second configuration, and a third configuration. The third configuration comprises: the top structure; the bottom structure; and a second intermediary structure disposed between the top structure and the bottom structure, wherein the second intermediary structure is detachably connected between the top structure and the bottom structure, and wherein the second intermediary structure connects the first portion of the first RF coil loop to the second portion of the first RF coil loop to form the first RF coil loop, and wherein the second intermediary structure is larger than the first intermediary structure.

In another aspect of the invention, an RF coil assembly kit is provided. The RF coil assembly kit comprises: a first top structure; a second top structure; and a bottom structure, wherein the bottom structure includes a bottom RF coil loop portion and bottom connections. The first top structure includes a first top RF coil loop portion and first top connections arranged to be connectable to the bottom connections of the bottom structure and to connect the first top RF coil loop portion to the bottom RF coil loop portion to form a first RF coil loop having a first size. The second top structure includes a second top RF coil loop portion and second top connections arranged to be connectable to the bottom connections of the bottom structure and to connect the second top RF coil loop portion to the bottom RF coil loop portion to form a second RF coil loop having a second size. The second top structure is larger than the first top structure, and the second RF coil loop is larger than the first RF coil loop.

In one or more embodiments, the second top structure comprises a cap structure and an intermediary structure, wherein the intermediary structure is arranged to be detachably connected to the cap structure, wherein the intermediary structure has the second top connections for connection to the bottom structure.

In one or more embodiments, the intermediary structure includes at least one capacitor, wherein the at least one capacitor is connectable in series between the second top RF coil loop portion and the bottom RF coil loop portion.

In one or more embodiments, the intermediary structure includes at least first and second capacitors, wherein the first capacitor and the second capacitor are connectable in series between the first top RF coil loop portion and the bottom RF coil loop portion, wherein the first capacitor and the second capacitor are disposed at opposite sides of the second RF coil loop.

In one or more embodiments, the second top structure comprises a cap structure and one of a first intermediary structure and a second intermediary structure, wherein the first intermediary structure and the second intermediary structure are arranged to be detachably connected to the cap structure, wherein the first intermediary structure and a second intermediary structure each have the second top connections for connection to the bottom structure.

In one or more embodiments, the bottom connections comprise: first bottom connections, wherein the first bottom connections are arranged for connecting the first top structure or the second top structure thereto when the first top structure or the second top structure has a first size; and second bottom connections, wherein the second bottom connections are arranged for connecting the first top structure or the second top structure thereto when the first top structure or the second top structure has a second size, wherein the second size is larger than the first size.

In one or more embodiments, the bottom RF coil loop portion includes one or more additional connections for connecting the bottom RF coil loop portion to at least one of a low noise amplifier, a power source, and a detuning circuit.

In still another aspect, a method includes: selecting a configuration for an RF coil assembly among a plurality of possible configurations; connecting the RF coil assembly in the selected configuration; and performing magnetic resonance imaging (MRI) on at least a portion of a patient using the RF coil assembly in the selected configuration. The plurality of possible configurations includes at least a first configuration and a second configuration, The first configuration comprises: a top structure, and a bottom structure, wherein the top structure includes a first portion of at least a first RF coil loop, wherein the bottom structure includes a second portion of the first RF coil loop, wherein the top structure is connected to the bottom structure, and wherein the first portion of the first RF coil loop is connected to the second portion of the first RF coil loop to form the first RF coil loop. The second configuration comprises: the top structure; the bottom structure; and a first intermediary structure disposed between the top structure and the bottom structure, wherein the first intermediary structure is detachably connected between the top structure and the bottom structure, and wherein the first intermediary structure connects the first portion of the first RF coil loop to the second portion of the first RF coil loop to form the first RF coil loop.

In one of more embodiments, the method includes attaching the RF coil assembly to a part of the patient prior to performing the MRI, wherein the part of the patient is one of a head, a knee, a wrist, an elbow, or an ankle.

In one or more embodiments, the first intermediary structure includes at least first and second capacitors, wherein the first capacitor is connected in the second configuration in series between the first portion of the first RF coil loop and the second portion of the first RF coil loop, and the second capacitor is connected in the second configuration in series between the first portion of the first RF coil loop and the second portion of the first RF coil loop, wherein the first capacitor and the second capacitor are disposed at opposite sides of the first RF coil loop.

In one of more embodiments, the plurality of possible configurations includes a third configuration. The third configuration comprises: the top structure; the bottom structure; and a second intermediary structure, wherein the second intermediary structure is detachably connected between the top structure and the bottom structure, wherein the second intermediary structure connects the first portion of the first RF coil loop to the second portion of the first RF coil loop to form the first RF coil loop, and wherein the second intermediary structure is larger than the first intermediary structure.

In one or more embodiments, the bottom structure comprises: first bottom connections, wherein the first bottom connections are arranged for connecting the top structure or the first intermediary structure thereto when the top structure has a first size; and second bottom connections, wherein the second bottom connections are arranged for connecting the top structure or the first intermediary structure thereto when the top structure has a second size, wherein the second size is larger than the first size.

In one or more embodiments, the method includes continuously monitoring a signal produced by the RF coil assembly during a set-up or calibration procedure of the RF coil assembly to ascertain at least one of an integrity of a connection between the top structure and the structure or a coil defect.

These and other aspects of the invention will be apparent from and elucidated with reference to the embodiments described hereinafter.

### BRIEF DESCRIPTION OF THE DRAWINGS

Fig. 1 illustrates an exemplary embodiment of a magnetic resonance imaging (MRI) apparatus.
Fig. 2 shows an example of a modular local RF coil assembly for performing MRI on a patient's head.
Fig. 3 shows examples of how RF coil loops for MRI may be divided into two RF coil loop portions.
Fig. 4 shows an example embodiment of a first configuration of an RF coil assembly.
Fig. 5 shows an example embodiment of a second configuration of an RF coil assembly.
Fig. 6 shows an example embodiment of a third configuration of an RF coil assembly.
Figs. 7A and 7B show additional example embodiments of an RF coil assembly.
Figs. 8A and 8B show example embodiments of an RF coil loop with a common bottom portion.
Fig. 9 is a flowchart illustrating an example embodiment of a method of magnetic resonance imaging with a configurable modular patient-adaptive RF coil assembly.

### DETAILED DESCRIPTION OF EMBODIMENTS

The terms "subject" and "patient" are used interchangeably herein, and both terms should be understood to refer to a person who undergoes a magnetic resonance imaging procedure, whether for medical diagnosis, or for research purposes.

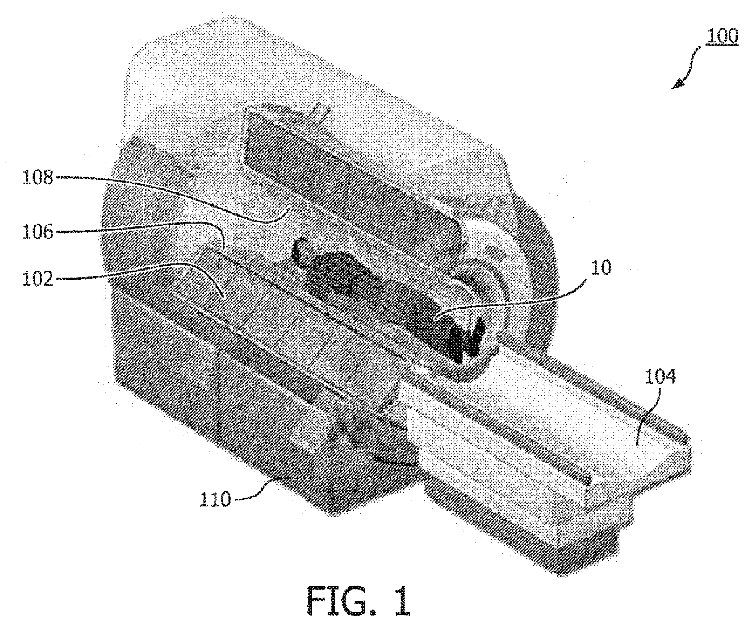

Fig. 1 illustrates an exemplary embodiment of a magnetic resonance imaging (MRI) apparatus 100. MRI apparatus 100 may include a magnet 102; a patient table 104 configured to hold a patient 10; gradient coils 106 configured to at least partially surround at least a portion of patient 10 for which MR imager 100 generates an image; a radio frequency (RF) coil 108 configured to apply a radio frequency signal to at least the portion of patient 10 which is being imaged, and to alter the alignment of the magnetic field; and a scanner 110 configured to detect changes in the magnetic field caused by the radio frequency signal.

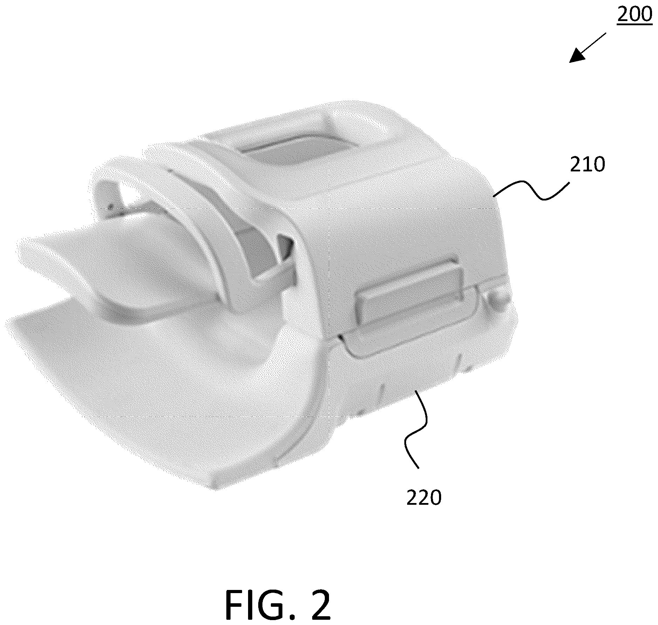

Beneficially, MRI apparatus 100 may include, or be operable with, one or more local RF coil assemblies (not shown in Fig. 1), such as those shown in Figs. 2-6, 7A, 7B, 8A and 8B and described below.

The general operation of an MRI apparatus is well known and therefore will not be repeated here.

Fig. 2 shows an example of a modular local RF coil assembly 200 for performing MRI on a patient's head. RF coil assembly 200 has one or more RF coil loops disposed therein. RF coil assembly 200 comprises a top structure 210 and a bottom structure 220 which are detachably connected together so as to place the one or more RF coil loops in the vicinity of the patient's head. In general, top structure 210 and bottom structure 220 are rigid or semi-rigid, and may comprise a material such as polycarbonate (PC), acrylonitrile butadiene styrene (ABS), or other plastic.

One limitation of RF coil assembly 200 is that it is a "one-size-fits-all" device. Thus, it must be large enough to fit the largest patient in the target population, and consequently the image quality for smaller patients is suboptimal.

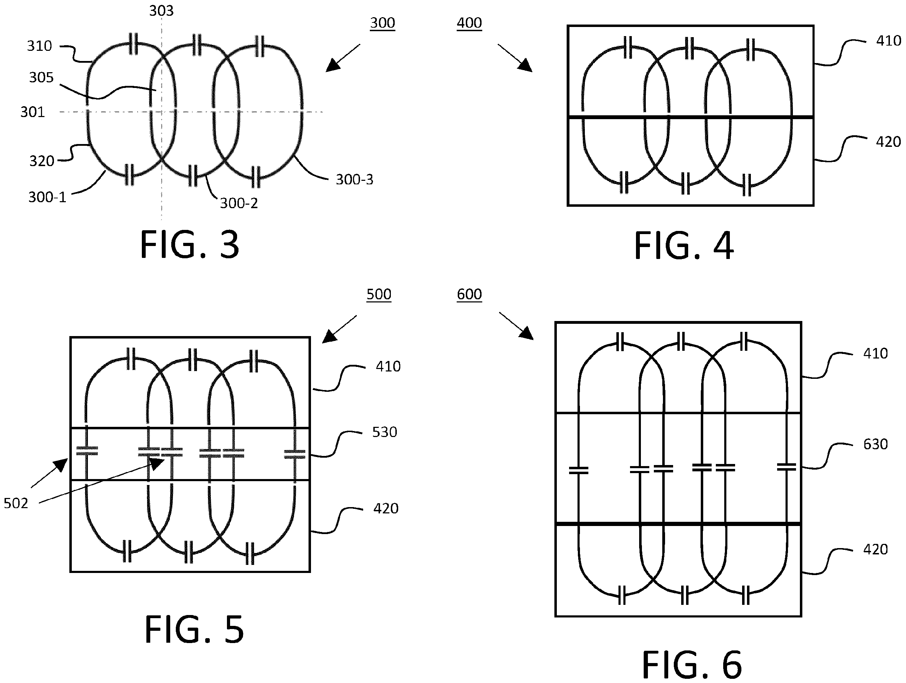

Fig. 3 shows examples of how RF coil loops 300 for MRI may be divided into two RF coil loop portions, 310 and 320, in an RF coil assembly. RF coil loops 300 comprise three RF coil loops 300-1, 300-2 and 300-3.

Here, the arrangement of RF coil loops 300-1, 300-2 and 300-3 has a clearly defined coil geometry to ensure a good decoupling of the RF coil loops or RF coil elements. The decoupling is based on very exact placement of the individual RF coil loops 300-1, 300-2 and 300-3 minimizing shared magnetic flux, e.g. by overlapping neighboring elements to create decoupling areas 305.

Beneficially, the split 301 between the top RF coil loop portion 310 and the bottom RF coil loop portion 320 is located in a specific section, fulfilling certain geometry conditions, so that (overlap) decoupling of the RF coil loops is not affected. Meanwhile, a split 303 through decoupling area 305 is not allowed as this would affect the decoupling.

To address issues described above with respect to RF coil assembly 200, for example, embodiments of a configurable modular patient-adaptive RF coil assembly for MRI are described below. In particular, as described below an RF coil assembly is configured to be selectively connected in at least a first configuration and a second configuration, for example depending on the size of a portion of a patient's anatomy which the RF coil assembly is to be applied. In some embodiments, the RF coil assembly may have a base or bottom part or structure which fits all patients in a target population, and a top part or structure which is to be attached or connected to the bottom structure can be selected or configured according to the size of a portion of a patient's anatomy which the RF coil assembly is to be applied. This can be realized in different ways, as described in various embodiments below.

Fig. 4 shows an example embodiment of a first configuration 400 of an RF coil assembly. In the first configuration 400, the RF coil assembly includes a top structure 410 and a bottom structure 420. Top structure 410 includes first portions of one or more RF coil loops (e.g., RF coil loops 300-1, 300-2 and 300-3), and bottom structure 420 includes second portions of the one or more RF coil loops. Top structure 410 is connected to bottom structure 420, and thereby the first portions of the one or more RF coil loops are connected to the second portions of the one or more RF coil loops.

Fig. 5 shows an example embodiment of a second configuration 500 of an RF coil assembly. In the second configuration 500, the RF coil assembly includes top structure 410 and bottom structure 420, and further includes a first intermediary structure 530. First intermediary structure 530 is disposed between top structure 410 and bottom structure 420, and is detachably connected between top structure 410 and bottom structure 420. First intermediary structure 530 connects the one or more first portions of the one or more RF coil loops (e.g. RF coil loops 300-1, 300-2 and 300-3) to the one or more second portions of the one or more RF coil loops.

As illustrated in Figs. 4 and 5, an RF coil assembly having a top structure 410 and a bottom structure 420 can have at least two different configurations, with the configurations differing on whether or not the first intermediary structure 530 is deployed or included in the RF coil assembly.

In the first configuration 400, first intermediary structure 530 is not deployed. The first configuration 400 may be selected and employed when the size of a portion of a particular patient's anatomy to which the RF coil assembly is to be applied can be comfortably accommodated within the space provided between top structure 410 and bottom structure 420 when they are connected together - that it when the particular patient's anatomy is relatively small. This allows the RF coil loop(s) of the RF coil assembly to be disposed relatively close to the area to be imaged by MRI to provide a greater signal or signal-to-noise ratio than if the space were unnecessarily enlarged by the addition of first intermediary structure 530.

On the other hand, in the second configuration 500, first intermediary structure 530 is deployed. The second configuration 500 may be selected and employed when the size of a portion of a particular patient's anatomy to which the RF coil assembly is to be applied is too large to be comfortably accommodated within the space provided between top structure 410 and bottom structure 420 when they are connected together - that it when the particular patient's anatomy is relatively large. In that case, first intermediary structure 530 permits the RF coil assembly to accommodate a larger patient anatomy. It may also allow the RF coil loop(s) of the RF coil assembly to be disposed relatively close to the area to be imaged by MRI to provide a strong signal.

In one or more embodiments, first intermediary structure 530 includes at least one capacitor 502, wherein the at least one capacitor is connected in the second configuration in series between the first portion of a first RF coil loop (e.g. RF coil loop 300-1) and the second portion of the first RF coil loop. In particular, as illustrated in Fig. 5, first intermediary structure 530 includes at least first and second capacitors 502, wherein the first capacitor 502 is connected in the second configuration 500 in series between the first portion of the first RF coil loop and the second portion of the first RF coil loop, and the second capacitor 502 is connected in the second configuration in series between the first portion of the first RF coil loop and the second portion of the first RF coil loop, and wherein the first capacitor 502 and the second capacitor 502 are disposed at opposite sides of the first RF coil loop. Similar capacitors may be employed for the other RF coil loops.

Fig. 6 shows an example embodiment of a third configuration 600 of an RF coil assembly. Third configuration 600 comprises: top structure 410, bottom structure 420, and a second intermediary structure 630. Second intermediary structure is disposed between top structure 410 and bottom structure 420, and detachably connected between top structure 410 and bottom structure 420. Second intermediary structure 630 connects first portions of the one or more RF coil loops (e.g., RF coil loops 300-1, 300-2 and 300-3) to the one or more second portions of the RF coil loops. Here, second intermediary structure 630 is larger than first intermediary structure 530.

Third configuration 600 may be selected and employed when the size of a portion of a patient's anatomy to which the RF coil assembly is to be applied is too large to be comfortably accommodated within the space provided by top structure 410, bottom structure 420 and first intermediary structure 530 in second configuration 500. In that case, the larger second intermediary structure 630 permits the RF coil assembly to accommodate an even larger patient anatomy. It may also allow the RF coil loop(s) of the RF coil assembly to be disposed relatively close to the area to be imaged by MRI to provide a strong signal.

In some embodiments, more than three configurations of the RF coil assembly may be possible, employing more than two intermediary structures of various sizes to allow eve greater flexibility and adaptation to the sizes of various patients' anatomies.

In operation, an MRI technician or clinician may select a configuration for the RF coil assembly which best matches or fits the size of a particular patient's anatomy which is to be imaged. For example, if the patient's head is to be imaged with MRI, the MRI technician or clinician may select configuration 400 when the particular patient's head is relatively small, and may select configuration 500 when the particular patient's head is relatively large (or, perhaps, configuration 600 when the particular patient's head is even larger). Similar configuration selections may be made with respect to the size of a patient's wrist, elbow, knee, ankle, etc. when those areas are to be imaged. Beneficially, the MRI technician or clinician may select the smallest configuration for which the particular patient's anatomy can be comfortably accommodated to maintain the RF coil loop(s) as close as possible to the area of the patient which is to be imaged, thereby increasing the signal level or signal-to-noise ratio. In other words, the selected configuration may be tailored to the particular individual who is undergoing the MRI.

Thus, the trade-offs which are inherent in a "one-size-fits-all" RF coil assembly as discussed above with respect to RF coil assembly 200, for example, may be mitigated.

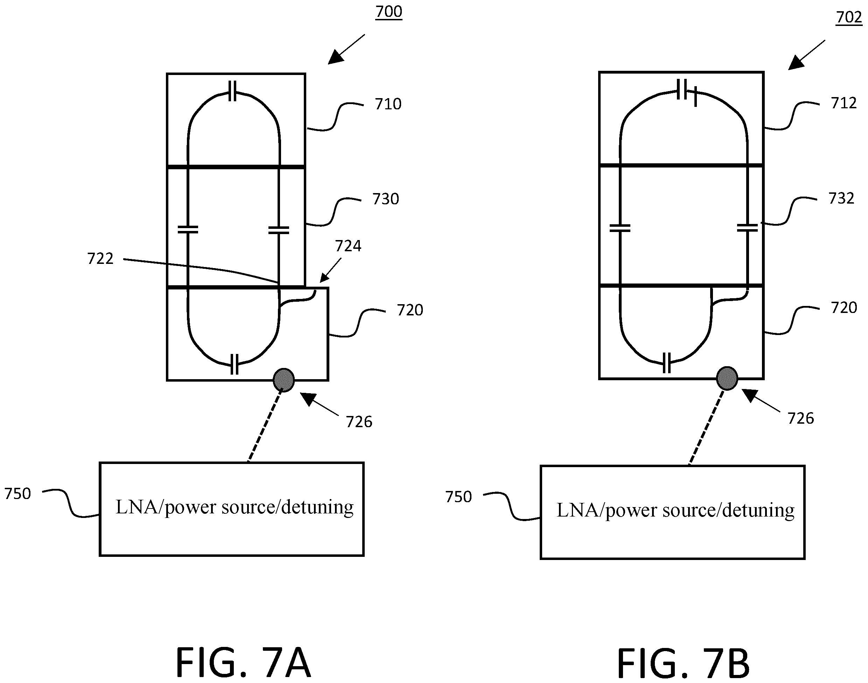

Figs. 7A and 7B show additional example embodiments of RF coil assemblies. Although only one RF coil loop is illustrated in Figs. 7A and 7B, it should be understood that in general the RF coil assemblies may have additional RF coil loops.

In particular, Fig. 7A shows an RF coil assembly 700. RF coil assembly 700 includes top structure 710, bottom structure 720, and intermediary structure 730. Intermediary structure 730 is disposed between top structure 710 and bottom structure 720, and is detachably connected between top structure 710 and bottom structure 720. Intermediary structure 730 connects one or more first portions of one or more RF coil loops (e.g. RF coil loops 300-1, 300-2 and 300-3) to one or more second portions of the one or more RF coil loops.

Meanwhile, Fig. 7B shows an RF coil assembly 702. RF coil assembly 702 includes top structure 712, bottom structure 720, and intermediary structure 732. Intermediary structure 732 is disposed between top structure 712 and bottom structure 720, and is detachably connected between top structure 712 and bottom structure 720. Intermediary structure 732 connects one or more first portions of one or more RF coil loops (e.g. RF coil loops 300-1, 300-2 and 300-3) to one or more second portions of the one or more RF coil loops.

Top structure 712 and intermediary structure 732 of RF coil assembly 702 are larger than top structure 710 and intermediary structure 730 of RF coil assembly 700.

Notably, RF coil assembly 700 and RF coil assembly 702 both employ the same bottom structure 720. Here, bottom structure 720 includes one or more first bottom connections 722 and one or more second bottom connections 724. In RF coil assembly 700, bottom structure 720 is connected to intermediary structure 730 via the one or more first bottom connections 722. In contrast, in RF coil assembly 702, bottom structure 720 is connected to intermediary structure 732 via the one or more second bottom connections 724.

As illustrated in Figs. 7A and 7B, the different bottom connections 722 and 724 in the bottom structure 720 allow different RF coil assemblies to be assembled with different RF coil loop sizes in the "horizontal" direction using the same bottom structure 720.

As show in Figs. 7A and 7B, RF coil assembly 700 and RF coil assembly 702 may each include one or more additional connections 726 for connecting the RF coil assembly to one or more of a low noise amplifier, a power source, and a detuning circuit (block 750).

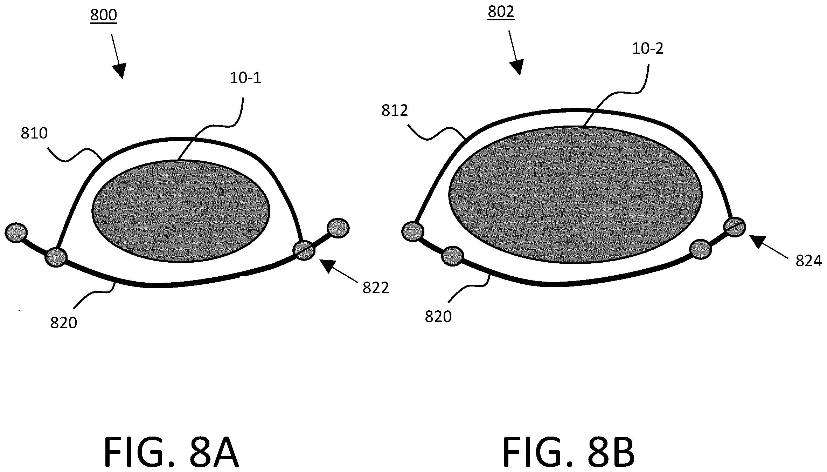

Figs. 8A and 8B show example embodiments of an RF coil loop with a common bottom portion. Although only one RF coil loop is illustrated in Figs. 8A and 8B, it should be understood that in general an RF coil assembly may have additional RF coil loops. Also, for simplicity of illustration, capacitors and/or additional detuning elements which may be present are not depicted in Figs. 8A ad 8B,

In particular, Fig. 8A shows an RF coil loop 800. RF coil loop 800 includes top coil loop portion 810 and bottom coil loop portion 820. Top coil loop portion 810 is detachably connected with bottom coil loop portion 820, and may be assembled prior to performing MRI on a patient anatomy 10-1.

Meanwhile, Fig. 8B shows an RF coil loop 802. RF coil loop 802 includes top coil loop portion 812 and bottom coil loop portion 820. Top coil loop portion 812 is detachably connected with bottom coil loop portion 820, and may be assembled prior to performing MRI on a patient anatomy 10-2.

Here, top coil loop portion 812 is larger than top coil loop portion 810.

Notably, RF coil loop 800 and RF coil loop 802 both employ the same bottom coil loop portion 820. Bottom coil loop portion 820 includes first bottom connections 822 and second bottom connections 824. In RF coil loop 800, bottom structure 820 is connected to top coil loop portion 810 via the one or more first bottom connections 822. In contrast, in RF coil loop 802, bottom structure 820 is connected to top coil loop portion 812 via the one or more second bottom connections 824. As a result, RF coil loop 802 is able to accommodate a patient anatomy 10-2 which is larger than a patient anatomy 10-1 which may be accommodated by RF coil loop 800. Also, in some embodiments, a transformer and/or sensor may be provided via first and/or second bottom connections 822/824.

As illustrated in Figs. 8A and 8B, the different bottom connections 822 and 824 in the bottom portion 820 allow different RF coil loops 800 and 802 of different sizes to be configured and assembled using one common bottom coil loop portion 820.

In some embodiments, a modular RF coil assembly kit may be provided for constructing an RF coil assembly in any of a variety of configurations, for example depending on the size of an anatomy of a patient to whom the RF coil assembly is to be applied for magnetic resonance imaging. In some embodiments, the RF coil assembly kit may include a first top structure (e.g., top structure 410), a second top structure, and a bottom structure (e.g., bottom structure 420). Beneficially, the bottom structure includes a bottom RF coil loop portion and bottom connections. The first top structure includes a first top RF coil loop portion and first top connections arranged to be connectable to the bottom connections of the bottom structure and to connect the first top RF coil loop portion to the bottom RF coil loop portion to form a first RF coil loop having a first size. The second top structure includes a second top RF coil loop portion and second top connections arranged to be connectable to the bottom connections of the bottom structure and to connect the second top RF coil loop portion to the bottom RF coil loop portion to form a second RF coil loop having a second size. The second top structure is larger than the first top structure, and as a result the second RF coil loop is larger than the first RF coil loop.

In some embodiments, second top structure comprises a cap structure (e.g., top structure 410) and an intermediary structure, where the intermediary structure is arranged to be detachably connected to the cap structure. The intermediary structure has the second top connections for connection to the bottom structure.

In one or more embodiments, the second top structure comprises a cap structure (e.g., top structure 410) and one of a first intermediary structure (e.g., first intermediary structure 530) and a second intermediary structure (e.g., second intermediary structure 630), wherein the first intermediary structure and the second intermediary structure are arranged to be detachably connected to the cap structure. The first intermediary structure and second intermediary structure each have the top connections for connection to the bottom structure.

In one or more embodiments, the bottom connections comprise: first bottom connections, wherein the first bottom connections are arranged for connecting the first top structure or the second top structure thereto when the first top structure or the second top structure has a first size; and second bottom connections, wherein the second bottom connections are arranged for connecting the first top structure or the second top structure thereto when the first top structure or the second top structure has a second size, wherein the second size is larger than the first size.

With a modular RF coil assembly kit as described above, prior to performing MRI on a patient, an MRI technician or clinician may select which components of the kit to connect together to configure an RF coil assembly which best matches or fits the size of a patient's anatomy which is to be imaged.

Beneficially, the top structures, bottom structures, and intermediary structures which are described above with respect to Figs. 4-6, 7A, 7B, 8A and 8B may be rigid or semi-rigid, and may comprise a material such as polypropylene, polycarbonate (PC), acrylonitrile butadiene styrene (ABS), or other plastic, beneficially a medical-grade plastic.

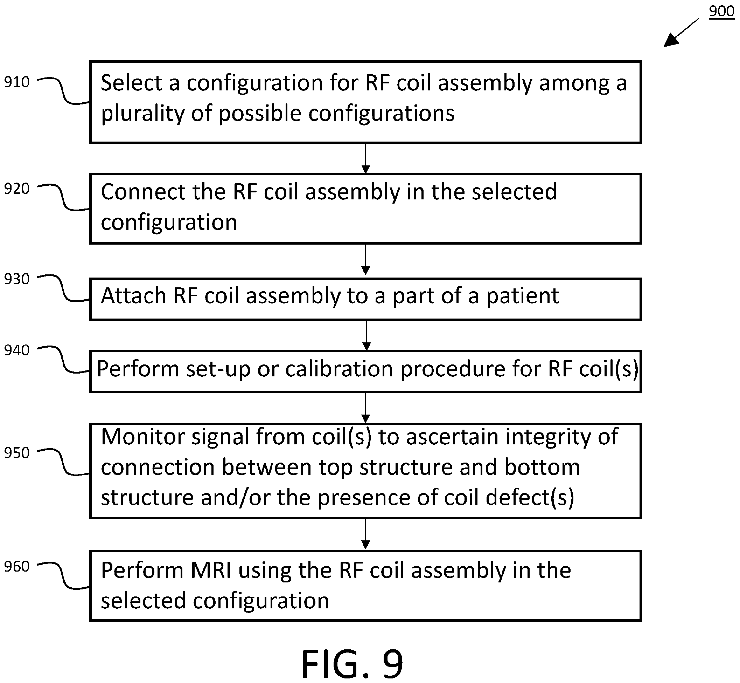

Fig. 9 is a flowchart illustrating an example embodiment of a method 900 of magnetic resonance imaging with a configurable modular patient-adaptive RF coil assembly.

An operation 910 includes selecting a configuration for an RF coil assembly among a plurality of configurations which are possible with the available components. For example, the possible configurations may include configurations 400, 500 and 600 discussed above.

Beneficially, in operation 910 an MRI technician or clinician may select a configuration for the RF coil assembly which best matches or fits the size of a particular patient's anatomy which is to be imaged. For example, if a patient's head is to be imaged with MRI, MRI technician or clinician may select a configuration such as configuration 400 above when a particular patient's head is relatively small, and may select configuration 500 above when a particular patient's head is relatively large (or, perhaps, configuration 600 when the particular patient's head is even larger). Similar configuration selections may be made with respect to the size of a patient's wrist, elbow, knee, ankle, etc. when those areas are to be imaged. Beneficially, the MRI technician or clinician may select the smallest configuration for which the particular patient's anatomy can be comfortably accommodated to maintain the RF coil loop(s) as close as possible to the area of the patient which is to be imaged, thereby increasing the signal level or signal-to-noise ratio.

An operation 920 includes connecting the RF coil assembly in the selected configuration.

An operation 930 includes attaching the RF coil assembly with the selected configuration to a part of the patient, such as the head, or a wrist, elbow, knee, ankle, etc.

An operation 940 includes performing a set-up or calibration procedure for the one or more RF coil loops of the RF coil assembly.

An operation 950 includes monitoring a signal from the one or more coil loop(s) of the RF coil assembly to ascertain the integrity of a connection between the top structure and the bottom structure and/or the presence of coil defect(s). In some embodiments, this may include the use of an algorithm to determine the moment in which the connections are made. In some embodiments, this algorithm detects changes of the signal magnitude and phase of the noise and spurious signals sampled during the RF coil set-up phase. Beneficially, a sudden transition from one state to the other indicates good connector conditions, whereas transitions with an undefined intermediate state (jumping signals) may indicate deteriorating connector conditions. This may be used for predictive maintenance, or when a certain expected end state of the set-up phase is not reached, as early indicator for an RF coil defect.

An operation 960 includes performing MRI on at least a portion of a patient using the RF coil assembly in the selected configuration.

In the method 900, none of the described operations should be construed to be essential to the invention of a particular claim below unless they are recited in the claim.

Disclosed herein is a configurable modular patient-adaptive RF coil assembly for MRI. The RF coil assembly may be assembled by selecting components from a prepared kit of components to produce a desired configuration. The configuration may be selected based at least in part based on the size of a particular patient's anatomy which is to be imaged. Also disclosed herein is a method of magnetic resonance imaging with a configurable modular patient-adaptive RF coil assembly.

Variations to the disclosed embodiments can be understood and effected by those skilled in the art in practicing the claimed invention, from a study of the drawings, the disclosure, and the appended claims.

In the claims, the word "comprising" does not exclude other elements or steps, and the indefinite article "a" or "an" does not exclude a plurality. Also, a single unit or device may fulfill the functions of several items recited in the claims. The mere fact that certain measures are recited in mutually different dependent claims does not indicate that a combination of these measures cannot be used to advantage. Furthermore, any reference signs in the claims should not be construed as limiting the scope.

## Claims

1. A radio frequency (RF) coil assembly (300, 400, 500, 600, 700, 702, 800, 802), comprises:
a top structure (410, 710, 712, 810, 812),
wherein the top structure includes a first portion of at least a first RF coil loop (300-1); and
a bottom structure (420, 720, 820),
wherein the bottom structure includes a second portion of the first RF coil loop (300-1),
wherein the RF coil assembly is configured to be selectively connected in at least a first configuration (400) and a second configuration (500),
wherein the first configuration comprises: the top structure and the bottom structure,
wherein the top structure is connected to the bottom structure, and
wherein the first portion of the first RF coil loop is connected to the second portion of the first RF coil loop to form the first RF coil loop,
wherein the second configuration comprises: the top structure, the bottom structure, and a first intermediary structure (530, 730),
wherein the first intermediary structure is detachably connected between the top structure and the bottom structure, and
wherein the first intermediary structure connects the first portion of the first RF coil loop to the second portion of the first RF coil loop to form the first RF coil loop.

2. The RF coil assembly (300, 400, 500, 600, 700, 702, 800, 802) of claim 1, wherein the first intermediary structure includes at least one capacitor (502), wherein the at least one capacitor is connected in the second configuration in series between the first portion of the first RF coil loop and the second portion of the first RF coil loop.

3. The RF coil assembly (300, 400, 500, 600, 700, 702, 800, 802) of any of the preceding claims, wherein the first intermediary structure includes at least first and second capacitors, wherein the first capacitor is connected in the second configuration in series between the first portion of the first RF coil loop and the second portion of the first RF coil loop, and the second capacitor is connected in the second configuration in series between the first portion of the first RF coil loop and the second portion of the first RF coil loop, wherein the first capacitor and the second capacitor are disposed at opposite sides of the first RF coil loop.

4. The RF coil assembly (300, 400,500, 600, 700, 702, 800, 802) of any of the preceding claims, wherein, the coil assembly further includes a second RF coil loop and a decoupling area (305) between the first RF coil loop and the second RF coil loop, wherein in the first configuration the first RF coil loop and the second RF coil loop are split at centers thereof between the top structure and the bottom structure.

5. The RF coil assembly (300, 400,500, 600, 700, 702, 800, 802) of any of the preceding claims, wherein the bottom structure comprises: first bottom connections, wherein the first bottom connections are arranged for connecting the top structure or the first intermediary structure thereto when the top structure has a first size; and second bottom connections, wherein the second bottom connections are arranged for connecting the top structure or the first intermediary structure thereto when the top structure has a second size, wherein the second size is larger than the first size.

6. The RF coil assembly (300, 400,500, 600, 700, 702, 800, 802) of any of the preceding claims, wherein the RF coil assembly includes one or more connections for connecting the RF coil assembly to at least one of a low noise amplifier, a power source, and a detuning circuit (750).

7. The RF coil assembly (300, 400,500, 600, 700, 702, 800, 802) of any of the preceding claims, wherein the RF coil assembly is configured to be selectively connected in at least the first configuration, the second configuration, and a third configuration, wherein the third configuration comprises: the top structure; the bottom structure; and a second intermediary structure (630, 732) disposed between the top structure and the bottom structure, wherein the second intermediary structure is detachably connected between the top structure and the bottom structure, and wherein the second intermediary structure connects the first portion of the first RF coil loop to the second portion of the first RF coil loop to form the first RF coil loop, and wherein the second intermediary structure is larger than the first intermediary structure.

8. A radio frequency (RF) coil assembly kit (700, 702, 800, 802), comprising:
a first top structure (710, 810);
a second top structure (712, 812); and
a bottom structure (720, 820),
wherein the bottom structure includes a bottom RF coil loop portion and bottom connections (722/724, 822/824),
wherein the first top structure includes a first top RF coil loop portion and first top connections arranged to be connectable to the bottom connections of the bottom structure and to connect the first top RF coil loop portion to the bottom RF coil loop portion to form a first RF coil loop having a first size,
wherein the second top structure includes a second top RF coil loop portion and second top connections arranged to be connectable to the bottom connections of the bottom structure and to connect the second top RF coil loop portion to the bottom RF coil loop portion to form a second RF coil loop having a second size,
wherein, the second top structure is larger than the first top structure, and the second RF coil loop is larger than the first RF coil loop.

9. The RF coil assembly kit (700, 702, 800, 802) of claim 8, wherein the second top structure comprises a cap structure (710) and an intermediary structure (730, 732), wherein the intermediary structure is arranged to be detachably connected to the cap structure, wherein the intermediary structure has the second top connections for connection to the bottom structure.

10. The RF coil assembly kit (700, 702, 800, 802) of any of claims 8-9, wherein the intermediary structure includes at least one capacitor (502), wherein the at least one capacitor is connectable in series between the second top RF coil loop portion and the bottom RF coil loop portion.

11. The RF coil assembly kit (700, 702, 800, 802) of any of claims 8-10, wherein the intermediary structure includes at least first and second capacitors (502), wherein the first capacitor and the second capacitor are connectable in series between the first top RF coil loop portion and the bottom RF coil loop portion, wherein the first capacitor and the second capacitor are disposed at opposite sides of the second RF coil loop.

12. The RF coil assembly kit (700, 702, 800, 802) of any of claims 8-11, wherein the second top structure comprises a cap structure (710) and one of a first intermediary structure (730) and a second intermediary structure (732), wherein the first intermediary structure and the second intermediary structure are arranged to be detachably connected to the cap structure, wherein the first intermediary structure and a second intermediary structure each have the second top connections for connection to the bottom structure.

13. The RF coil assembly kit (700, 702, 800, 802) of any of claims 8-12, wherein the bottom RF coil loop portion includes one or more additional connections (726) for connecting the RF coil to at least one of a low noise amplifier, a power source, and a detuning circuit.

14. A method (900), comprising:
selecting (910) a configuration for a radio frequency (RF) coil assembly (300, 400, 500, 600, 700, 702, 800, 802) among a plurality of possible configurations;
connecting (920) the RF coil assembly in the selected configuration; and
performing (960) magnetic resonance imaging (MRI) on at least a portion of a patient using the RF coil assembly in the selected configuration,
wherein the plurality of possible configurations includes at least a first configuration and a second configuration,
wherein the first configuration comprises:
a top structure (410, 710, 712, 810, 812), and
a bottom structure (420, 720, 820),
wherein the top structure includes a first portion of at least a first RF coil loop (300-1),
wherein the bottom structure includes a second portion of the first RF coil loop,
wherein the top structure is connected to the bottom structure, and
wherein the first portion of the first RF coil loop is connected to the second portion of the first RF coil loop to form the first RF coil loop,
wherein the second configuration comprises:
the top structure;
the bottom structure; and
a first intermediary structure (530, 730),
wherein the first intermediary structure is detachably connected between the top structure and the bottom structure, and
wherein the first intermediary structure connects the first portion of the first RF coil loop to the second portion of the first RF coil loop to form the first RF coil loop.

15. The method (900) of claim 14, further comprising continuously monitoring (950) a signal produced by the RF coil assembly during a set-up or calibration procedure of the RF coil assembly to ascertain at least one of an integrity of a connection between the top structure and the structure or an RF coil defect.
